# DEMANDE DE BREVET EUROPEEN

(11) **EP 4 762 980 A1**
(43) Date de publication de la demande: **24.06.2026**
(21) Numéro de dépôt: 24222572.0
(22) Date de dépôt: 20.12.2024
(51) Int. Cl.: A44C 27/00, G04B 19/12, G04B 37/22, G04B 45/00

(54) **COMPOSANT D'HABILLAGE COMPRENANT UN EMPILEMENT DE COUCHES INTERFÉRENTIELLES DÉPOSÉ SUR UNE FACE RÉALISÉE COMPRENANT AU MOINS 50% EN MASSE DE TITANE**

(71) Demandeur: The Swatch Group Research and Development Ltd, 2074 Marin (CH)
(72) Inventeur: HALLER, Camille, 1400 Yverdon-les-Bains (CH); CURCHOD, Loïc, 1004 Lausanne (CH); BAUDOZ, Marie, 25500 Morteau (CH); POLY, Giovanni, 25140 Charquemont (FR)
(74) Mandataire: ICB SA

(57) **Abrégé**

L'invention concerne un composant d'habillage (10) d'horlogerie, de bijouterie ou de joaillerie, comprenant un substrat (100) présentant une face support (101) réalisée dans un matériau comprenant au moins 50% en masse de titane, sur laquelle est déposé un empilement de couches minces diélectriques (110) semi-transparentes comprenant au moins trois couches, dont une couche de base (111) réalisée en TiO₂ reposant sur la face support (101), une couche terminale (112) réalisée en TiO₂ et une couche intermédiaire (113) réalisée en Al₂O₃ et déposée entre la couche de base (111) et la couche terminale (112).

## Description

### Domaine technique de l'invention

L'invention relève du domaine de l'horlogerie, de la bijouterie ou de la joaillerie, et concerne plus particulièrement un composant d'habillage d'horlogerie, de bijouterie ou de joaillerie.

Dans le présent texte, les termes « composant d'habillage » désignent, de façon communément admise dans les domaines précités, un composant visible pour un utilisateur, et ayant une fonction notamment décorative, c'est-à-dire contribuant à l'aspect visuel d'un objet.

### Arrière-plan technologique

Dans les domaines de l'horlogerie, de la bijouterie et de la joaillerie, les acteurs économiques sont constamment à la recherche de nouvelles solutions de décoration pour modifier l'apparence de leurs produits afin d'en augmenter l'attractivité ou afin de se distinguer de la concurrence.

Par exemple, dans le domaine de l'horlogerie en particulier, il est connu de colorer des composants d'habillage par le dépôt, sur un substrat, de couches minces par des méthodes de dépôt sous vide, par exemple par dépôt physique en phase vapeur ou par dépôt chimique en phase vapeur. Cependant, selon la nature du substrat et des couches déposées, il est possible de rencontrer des problèmes d'accroche. Cet inconvénient nécessite de déposer une couche d'accroche, ce qui participe à complexifier le procédé de coloration du composant.

En ce qui concerne en particulier les composants d'habillage comprenant un substrat réalisé en titane, il est possible de résoudre l'inconvénient précité par la mise en oeuvre d'un procédé d'anodisation du substrat afin de colorer le composant d'habillage. Cependant, le procédé d'anodisation est relativement long à réaliser dans la mesure où il nécessite des temps de cycle conséquents pour faire croitre une couche d'oxyde sur le substrat et qu'il implique la réalisation d'une multitude d'étapes. Par ailleurs, entre chaque étape, les composants d'habillage doivent être manipulés, ce qui augmente le risque d'endommagement de ces derniers.

### Résumé de l'invention

L'invention résout les inconvénients précités et concerne, à cet effet, un composant d'habillage d'horlogerie, de bijouterie ou de joaillerie, comprenant un substrat présentant une face support réalisée dans un matériau comprenant au moins 50% en masse de titane, sur laquelle est déposé un empilement de couches minces diélectriques semi-transparentes comprenant au moins trois couches, dont une couche de base réalisée en TiO₂ reposant sur la face support, une couche terminale réalisée en TiO₂ et une couche intermédiaire réalisée en Al₂O₃ et déposée entre la couche de base et la couche terminale.

L'invention permet avantageusement de garantir une excellente adhérence entre la face support et l'empilement de couches minces diélectriques du fait de l'affinité chimique entre ladite face et la couche de base. L'empilement de couches permet en outre de conférer une couleur vive et précise au composant d'habillage.

Dans des modes particuliers de réalisation, l'invention peut comporter en outre l'une ou plusieurs des caractéristiques suivantes, prises isolément ou selon toutes les combinaisons techniquement possibles.

Dans des modes particuliers de réalisation, le substrat est formé par un corps réalisé en titane pur ou en alliage de titane et comprenant la face support.

Dans des modes particuliers de réalisation, le substrat comprend un corps sur lequel est formé un revêtement réalisé en nitrure de titane, en carbure de titane, en oxyde de titane ou en carbonitrure de titane, le revêtement comprenant la face support.

Dans des modes particuliers de réalisation, l'empilement de couches minces diélectriques comporte trois couches intermédiaires parmi lesquelles deux couches minces réalisées en Al₂O₃ sont séparées par une couche réalisée en TiO₂.

Dans des modes particuliers de réalisation, les couches de l'empilement de couches minces diélectriques présentent des épaisseurs choisies de sorte à conférer une couleur interférentielle au composant d'habillage caractérisée, dans l'espace CIELAB en mode réflexion de l'illuminant normalisé D65, avec un observateur de 10° et une géométrie de mesure di:8°, par les paramètres L* = [20 ; 30], a* = [0 ; 10], b* = [-5 ; 5].

Dans des modes particuliers de réalisation, la couche de base présente une épaisseur comprise entre 20 nm et 30nm, la couche intermédiaire présente une épaisseur comprise entre 1 nm et 10 nm et la couche terminale présente une épaisseur comprise entre 1 nm et 5 nm.

### Brève description des figures

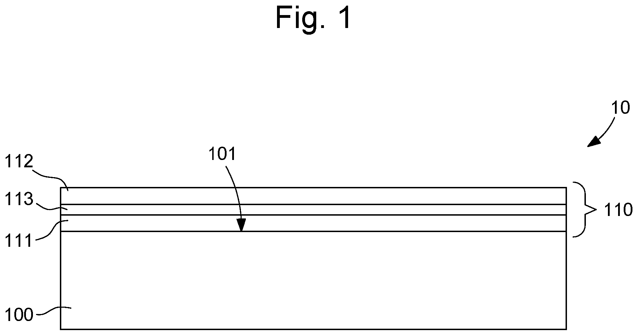

D'autres caractéristiques et avantages de l'invention apparaîtront à la lecture de la description détaillée suivante donnée à titre d'exemple nullement limitatif, en référence à la figure 1 qui représente schématiquement une vue de section d'un composant d'habillage respectivement selon un exemple préféré de réalisation de la présente invention.

On note que la figure n'est pas dessinée à l'échelle pour des raisons de clarté.

### Description détaillée de l'invention

La présente invention concerne un composant d'habillage 10 d'horlogerie, de bijouterie ou de joaillerie comprenant un substrat 100 présentant une face support 101 réalisée dans un matériau comprenant au moins 50% en masse de titane, c'est-à-dire dans un matériau comprenant du titane.

Le composant d'habillage 10 selon l'invention est représenté schématiquement sur la figure 1 et est particulièrement adapté à former un cadran pour une pièce d'horlogerie, ou toute autre pièce préférentiellement interne de la pièce d'horlogerie, telle que des appliques ou des aiguilles.

Dans le présent texte, le substrat peut être réalisé dans un titane pur, un alliage de titane, un nitrure de titane, un carbure de titane, un oxyde de titane, un carbonitrure de titane, etc.

Le substrat 100 est formé par un corps qui est, dans un exemple de réalisation de l'invention, réalisé dans un matériau comprenant au moins 50% en masse de titane. La face support 101 est donc formée par une face du corps.

Dans d'autres exemples de réalisation de l'invention, le substrat 100 peut comprendre un corps réalisé par exemple dans un matériau différent du titane et sur lequel est réalisé un revêtement comprenant au moins 50% en masse de titane. La face support 101 est donc formée par une face du revêtement.

Naturellement, la nature du matériau comprenant au moins 50% en masse de titane détermine si la face support 101 est formée par le corps ou par le revêtement. Par exemple, si le matériau comprenant au moins 50% en masse de titane est un titane pur ou un alliage de titane, il peut constituer le corps du substrat 100. Si le matériau comprenant au moins 50% en masse de titane est un nitrure de titane, un carbure de titane ou un carbonitrure de titane, il peut constituer un revêtement déposé par des méthodes de dépôt adaptés, tels que les méthodes de dépôt physique en phase vapeur ou les méthodes de dépôt chimique en phase vapeur. Par ailleurs, si le matériau comprenant au moins 50% en masse de titane est un oxyde de titane, il peut constituer un revêtement réalisé par anodisation, de façon connue de l'homme du métier.

Le composant d'habillage 10 comporte sur sa face support 101, un empilement de couches minces diélectriques 110 semi-transparentes, c'est-à-dire au moins transparent dans le domaine du visible. L'empilement de couches minces diélectriques comprend au moins trois couches, chacune déposée par une méthode de dépôt de couches minces atomiques connu par l'homme du métier sous l'acronyme « ALD » en langue anglaise pour « Atomic Layer Déposition ». Chaque couche de l'empilement de couches minces diélectriques 110 présente une épaisseur comprise entre un nanomètre et quelques dizaines de nanomètres. Cette caractéristique permet à la fois de protéger la face support 101 du composant d'habillage 10 contre les agressions chimiques et environnementales, telle que l'humidité, et de la colorer par effet interférentiel précisément choisi et de façon répétable et robuste. Aussi, l'épaisseur de l'empilement de couches minces diélectriques 110 est homogène et conforme sur l'ensemble de sa surface.

La face support 101 peut présenter une structuration, par exemple réalisée par usinage mécanique, par exemple une gravure manuelle ou un usinage avec une machine-outil à commande numérique, par usinage chimique ou au laser. La structuration est formée par des creux et des sommets, la distance entre les creux et les sommets étant, par exemple, égale à au moins 1 µm, et son aspect est avantageusement préservé par l'empilement de couches minces diélectriques 110.

L'empilement de couches minces diélectriques 110 est formé par au moins trois couches minces diélectriques, dont une couche de base 111 reposant sur la face support 101, une couche terminale 112 et une couche intermédiaire 113 déposée entre la couche de base 111 et la couche terminale 112, comme visible sur la figure 1.

La couche de base 111 et la couche terminale 112 sont réalisées en TiO₂ et la couche intermédiaire 113 est réalisée en Al₂O₃. La couche terminale 112 en TiO₂, en particulier, permet avantageusement de garantir la protection chimique du composant d'habillage.

Il y a lieu de noter que l'empilement de couches minces diélectriques 110 peut comporter trois couches intermédiaires 113, parmi lesquelles deux couches minces réalisées en Al₂O₃ sont séparées par une couche réalisée en TiO₂.

Par ailleurs, il est envisageable que l'empilement de couches minces diélectriques 110 comporte plus de trois couches intermédiaires 113, pourvu que ces couches consistent en une alternance de couches réalisées en Al₂O₃ et en TiO₂, et que les couches intermédiaires 113 agencées contre la couche de base 111 et contre la couche terminale 112 soient réalisées en Al₂O₃.

Avantageusement, la couche de base 111 présente une excellente affinité chimique avec la face support 101 sur laquelle elle est déposée, ce qui assure une très bonne accroche de la couche de base 111, et donc de l'empilement de couches minces diélectriques 110, et permet d'augmenter la vitesse de dépôt de la couche de base 111.

L'empilement de couches minces diélectriques 110 permet de conférer au composant d'habillage 10 une couleur interférentielle, dont la teinte dépend de l'épaisseur de chaque couche mince de l'empilement de couches minces diélectriques 110, de leur agencement et de leur nombre, et du matériau constituant la face support 101. Ainsi, la couleur interférentielle générée par les caractéristiques de l'invention est avantageusement très précise.

Dans un exemple préféré de réalisation de l'invention, les couches de l'empilement de couches minces diélectriques 110 présentent des épaisseurs choisies de sorte à conférer une couleur interférentielle au composant d'habillage 10 caractérisée, dans l'espace CIELAB en mode réflexion de l'illuminant normalisé D65, avec un observateur de 10° et une géométrie de mesure di:8°, par les paramètres L* = [20 ; 30], a* = [0 ; 10], b* = [-5 ; 5], et plus précisément par les paramètres L* = 26, a* = 30, b* = 4.

Ainsi, dans cette première variante, le composant d'habillage 10 présente un aspect rouge bordeaux.

Dans cet exemple de réalisation préféré, chaque couche de l'empilement de couches minces diélectriques 110 présente une épaisseur comprise entre un et quelques dizaines de nanomètres, par exemple entre 1 nm et 30 nm. En particulier, la couche de base 111 présente une épaisseur comprise entre 20 nm et 30nm, la couche intermédiaire 113 présente une épaisseur comprise entre 1 nm et 10 nm et la couche terminale 112 présente une épaisseur comprise entre 1 nm et 5 nm.

De manière plus générale, il est à noter que les modes de mise en oeuvre et de réalisation considérés ci-dessus ont été décrits à titre d'exemples non limitatifs, et que d'autres variantes sont par conséquent envisageables.

## Revendications

1. Composant d'habillage (10) d'horlogerie, de bijouterie ou de joaillerie, **caractérisé en ce qu'**il comprend un substrat (100) présentant une face support (101) réalisée dans un matériau comprenant au moins 50% en masse de titane, sur laquelle est déposé un empilement de couches minces diélectriques (110) semi-transparentes comprenant au moins trois couches, dont une couche de base (111) réalisée en TiO₂ reposant sur la face support (101), une couche terminale (112) réalisée en TiO₂ et une couche intermédiaire (113) réalisée en Al₂O₃ et déposée entre la couche de base (111) et la couche terminale (112).

2. Composant d'habillage (10) selon la revendication 1, dans lequel le substrat (100) est formé par un corps réalisé en titane pur ou en alliage de titane et comprenant la face support (101).

3. Composant d'habillage (10) selon la revendication 1, dans lequel le substrat (100) comprend un corps sur lequel est formé un revêtement réalisé en nitrure de titane, en carbure de titane, en oxyde de titane ou en carbonitrure de titane, le revêtement comprenant la face support (101).

4. Composant d'habillage (10) selon l'une des revendications 1 à 3, dans lequel l'empilement de couches minces diélectriques (110) comporte trois couches intermédiaires (113) parmi lesquelles deux couches minces réalisées en Al₂O₃ sont séparées par une couche réalisée en TiO₂.

5. Composant d'habillage (10) selon la revendication 1 à 3, dans lequel les couches de l'empilement de couches minces diélectriques (110) présentent des épaisseurs choisies de sorte à conférer une couleur interférentielle au composant d'habillage (10) caractérisée, dans l'espace CIELAB en mode réflexion de l'illuminant normalisé D65, avec un observateur de 10° et une géométrie de mesure di:8°, par les paramètres L* = [20 ; 30], a* = [0 ; 10], b* = [-5 ; 5].

6. Composant d'habillage (10) selon la revendication 5, dans lequel la couche de base (111) présente une épaisseur comprise entre 20 nm et 30nm, la couche intermédiaire (113) présente une épaisseur comprise entre 1 nm et 10 nm et la couche terminale (112) présente une épaisseur comprise entre 1 nm et 5 nm.
